(19) Europäisches Patentamt / European Patent Office / Office européen des brevets

(11) **EP 3 514 388 B1**

(12) **FASCICULE DE BREVET EUROPEEN**

(45) Date de publication et mention
de la délivrance du brevet:
**11.03.2020 Bulletin 2020/11**

(21) Numéro de dépôt: **19151044.5**

(22) Date de dépôt: **09.01.2019**

(51) Int Cl.:
*F04B 43/04* (2006.01)   *H01L 41/047* (2006.01)
*H01L 41/083* (2006.01)   *H01L 41/09* (2006.01)
*H04R 17/00* (2006.01)

(54) **TRANSDUCTEUR PIÉZOÉLECTRIQUE**

PIEZOELEKTRISCHER WANDLER

PIEZOELECTRIC TRANSDUCER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.01.2018 FR 1850472**

(43) Date de publication de la demande:
**24.07.2019 Bulletin 2019/30**

(73) Titulaire: **Commissariat à l'Energie Atomique et
aux Energies
Alternatives
75015 Paris (FR)**

(72) Inventeurs:
• **DEJAEGER, Remy**
**69210 EVEUX (FR)**
• **FAIN, Bruno**
**38100 GRENOBLE (FR)**

(74) Mandataire: **Cabinet Beaumont
4, Place Robert Schuman
B.P. 1529
38025 Grenoble Cedex 1 (FR)**

(56) Documents cités:
EP-A1- 2 039 934        JP-A- H0 354 383
US-A1- 2010 239 444

**Description**

Domaine

La présente demande concerne le domaine des transducteurs piézoélectriques.

Exposé de l'art antérieur

Un transducteur piézoélectrique comprend classiquement un élément de conversion piézoélectrique constitué d'une couche en un matériau piézoélectrique disposée entre deux électrodes.

L'application d'une tension entre les deux électrodes génère un champ électrique dans la couche piézoélectrique, provoquant une déformation mécanique de la couche piézoélectrique. Cet effet de transduction électromécanique peut être utilisé pour diverses applications, par exemple pour réaliser un actionneur électromécanique, un haut-parleur, un générateur d'ondes ultrasonores, etc.

A l'inverse, l'application d'une déformation mécanique à la couche piézoélectrique entraine une variation du champ électrique et donc une accumulation de charges dans les deux électrodes de l'élément de conversion piézoélectrique. Cet effet de transduction mécanoélectrique peut être utilisé pour diverses applications, par exemple pour réaliser un capteur de pression ou de déformation, un microphone, etc.

La présente demande concerne plus particulièrement la réalisation de transducteurs piézoélectriques électromécaniques.

Il serait souhaitable de pouvoir améliorer au moins en partie certains aspects des transducteurs piézoélectriques électromécaniques connus.

En particulier, il serait souhaitable de pouvoir augmenter l'amplitude du déplacement mécanique produit au sein du transducteur pour une tension de commande donnée.

Résumé

Ainsi, un mode de réalisation prévoit un transducteur piézoélectrique comportant :

une première couche piézoélectrique en un matériau non ferroélectrique, la première couche ayant une face avant et une face arrière ;
une première couche conductrice disposée sur la face avant de la première couche piézoélectrique ;
une deuxième couche piézoélectrique en un matériau non ferroélectrique disposée sur la face avant de la première couche conductrice ;
une première électrode disposée sur la face avant de la deuxième couche piézoélectrique ;
une deuxième électrode disposée sur la face arrière de la première couche piézoélectrique, en vis à vis de la première électrode ;

une troisième électrode disposée sur la face avant de la deuxième couche piézoélectrique ;
une quatrième électrode disposée sur la face arrière de la première couche piézoélectrique, en vis-à-vis de la troisième électrode ; et
un circuit de commande configuré pour :

dans une première phase de fonctionnement, appliquer simultanément une tension non nulle sur la première électrode, une tension non nulle sur la quatrième électrode, et des tensions sensiblement nulles sur les deuxième et troisième électrodes ; et

dans une deuxième phase de fonctionnement, appliquer simultanément une tension non nulle sur la deuxième électrode, une tension non nulle sur la troisième électrode, et des tensions sensiblement nulles sur les première et quatrième électrodes.

Selon un mode de réalisation, les première et deuxième couches piézoélectriques ont des polarisations $\vec{P}$ identiques, et le circuit de commande est configuré pour, dans la première configuration, appliquer des tensions de polarité opposées sur les première et quatrième électrodes, et, dans la deuxième configuration, appliquer des tensions de polarité opposées sur les deuxième et troisième électrodes.

Selon un mode de réalisation, les première et deuxième couches piézoélectriques ont chacune un pôle négatif du côté de leur face arrière et un pôle positif du côté de leur face avant, et le circuit de commande est configuré pour, dans la première configuration, appliquer une tension positive sur la première électrode et une tension négative sur la quatrième électrode, et, dans la deuxième configuration, appliquer une tension négative sur la deuxième électrode et une tension positive sur la troisième électrode.

Selon un mode de réalisation, les première et deuxième couches piézoélectriques ont des polarisations $\vec{P}$ opposées, et le circuit de commande est configuré pour, dans la première configuration, appliquer des tensions de même polarité sur les première et quatrième électrodes, et, dans la deuxième configuration, appliquer des tensions de même polarité sur les deuxième et troisième électrodes.

Selon un mode de réalisation, la première couche piézoélectrique a un pôle positif du côté de sa face arrière et un pôle négatif du côté de sa face avant, et la deuxième couche piézoélectrique a un pôle négatif du côté de sa face arrière et un pôle positif du côté de sa face avant, et le circuit de commande est configuré pour, dans la première configuration, appliquer une tension positive sur la première électrode et une tension positive sur la quatrième électrode, et, dans la deuxième configuration, appliquer une tension positive sur la deuxième électrode et une tension positive sur la troisième électrode.

Selon un mode de réalisation, le circuit de commande est configuré pour, dans la première configuration, appliquer des tensions continues sur les première et quatrième électrodes, et, dans la deuxième configuration, appliquer des tensions continues sur les deuxième et troisième électrodes.

Selon un mode de réalisation, le circuit de commande est configuré pour, dans la première configuration, appliquer des tensions variables sur les première et quatrième électrodes, et, dans la deuxième configuration, appliquer des tensions variables sur les deuxième et troisième électrodes.

Selon un mode de réalisation, le circuit de commande comprend :

des premier et deuxième noeuds d'application d'une tension de commande alternative ;
une première diode montée en direct entre le premier noeud et la première électrode ; et
une deuxième diode montée en inverse entre le deuxième noeud et la deuxième électrode.

Selon un mode de réalisation, le circuit de commande comprend en outre un premier circuit d'inversion de polarité reliant la première électrode à la quatrième électrode, et un deuxième circuit d'inversion de polarité reliant la deuxième électrode à la troisième électrode.

Selon un mode de réalisation, l'empilement comprenant les première et deuxième couches piézoélectriques et la première couche conductrice forme une membrane suspendue sur un support rigide.

Selon un mode de réalisation, les première et deuxième électrodes sont disposées en vis-à-vis d'une partie centrale de la membrane, et les troisième et quatrième électrodes sont disposées en vis-à-vis d'une partie périphérique de la membrane.

Selon un mode de réalisation, les tensions appliquées par le circuit de commande sur les première, deuxième, troisième et quatrième électrodes sont référencées par rapport à la première couche conductrice.

Un autre mode de réalisation prévoit un procédé de commande d'un transducteur piézoélectrique comportant :

une première couche piézoélectrique en un matériau non ferroélectrique, la première couche ayant une face avant et une face arrière ;
une première couche conductrice disposée sur la face avant de la première couche piézoélectrique ;
une deuxième couche piézoélectrique en un matériau non ferroélectrique disposée sur la face avant de la première couche conductrice ;
une première électrode disposée sur la face avant de la deuxième couche piézoélectrique ;
une deuxième électrode disposée sur la face arrière de la première couche piézoélectrique, en vis à vis de la première électrode ;
une troisième électrode disposée sur la face avant de la deuxième couche piézoélectrique ; et
une quatrième électrode disposée sur la face arrière de la première couche piézoélectrique, en vis-à-vis de la troisième électrode,
ce procédé comportant :

dans une première phase de fonctionnement, appliquer simultanément une tension non nulle sur la première électrode, une tension non nulle sur la quatrième électrode, et des tensions sensiblement nulles sur les deuxième et troisième électrodes ; et
dans une deuxième phase de fonctionnement, appliquer simultanément une tension non nulle sur la deuxième électrode, une tension non nulle sur la troisième électrode, et des tensions sensiblement nulles sur les première et quatrième électrodes.

## Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe schématique d'un exemple d'un transducteur piézoélectrique ;
la figure 2 est une vue en coupe schématique d'un autre exemple d'un transducteur piézoélectrique ;
la figure 3 est une vue en coupe schématique d'un autre exemple d'un transducteur piézoélectrique ;
la figure 4 est un chronogramme illustrant un exemple d'un procédé de commande d'un transducteur piézoélectrique ;
la figure 5 est un chronogramme illustrant un exemple d'un procédé de commande d'un transducteur piézoélectrique selon un mode de réalisation ;
la figure 6 est un diagramme illustrant un avantage du procédé de commande de la figure 5 ;
la figure 7 illustre un autre exemple d'un procédé de commande d'un transducteur piézoélectrique selon un mode de réalisation ;
la figure 8 est un schéma électrique simplifié d'un exemple d'un circuit de commande d'un transducteur piézoélectrique selon un mode de réalisation ;
la figure 9 est un schéma électrique plus détaillé d'un exemple de réalisation d'un circuit d'inversion de polarité du circuit de commande de la figure 8 ;
la figure 10 est une vue en coupe d'un autre exemple d'un transducteur piézoélectrique selon un mode de réalisation ; et
la figure 11 est un chronogramme illustrant un exemple d'un procédé de commande du transducteur de la figure 10.

Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les diverses utilisations qui peuvent être faites des transducteurs piézoélectriques décrits n'ont pas été détaillées, les modes de réalisation décrits étant compatibles avec les applications usuelles des transducteurs piézoélectriques. De plus, les procédés de fabrication des transducteurs piézoélectriques décrits n'ont pas été détaillés, les transducteurs décrits pouvant être réalisés par des procédés de fabrication usuels de transducteurs piézoélectriques, moyennant des adaptations éventuelles à la portée de l'homme du métier à la lecture de la présente description.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "à l'aplomb de", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

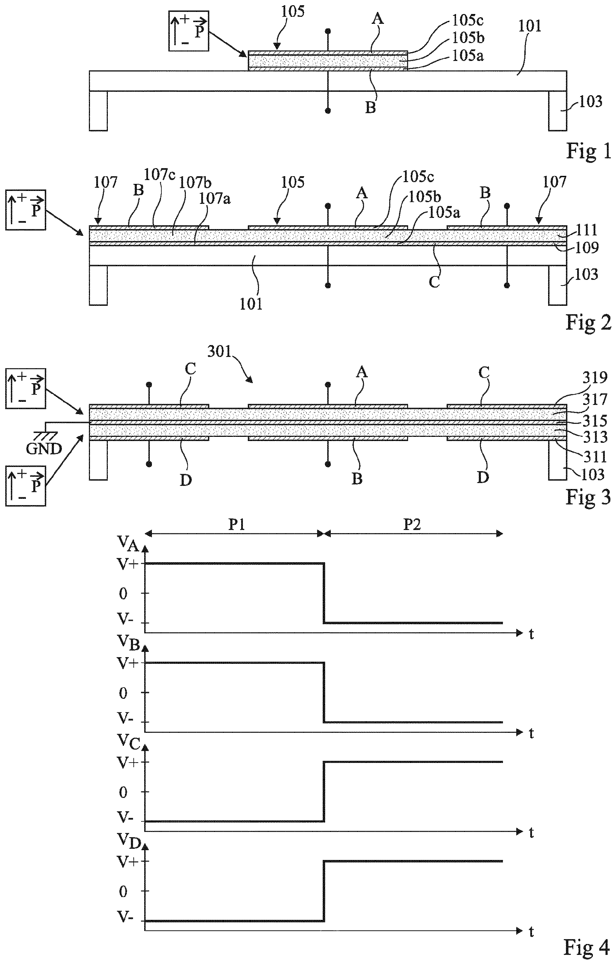

La figure 1 est une vue en coupe illustrant de façon schématique un exemple d'un transducteur piézoélectrique.

Le transducteur de la figure 1 comprend une membrane flexible 101, par exemple une membrane élastique, suspendue sur un support rigide 103. Le support 103 a par exemple la forme d'un cadre ou anneau fermé, par exemple de forme circulaire ou rectangulaire (en vue de dessus). A titre de variante, le support 103 a la forme d'un cadre ou anneau ouvert, ou encore d'un ou plusieurs piliers disjoints. Le support 103 est disposé en vis-à-vis d'une partie périphérique de la membrane 101, la membrane 101 étant, dans cette partie, fixée par sa face inférieure à la face supérieure du support 103. Une partie centrale de la membrane est quant à elle libre de se déplacer selon une direction orthogonale à la membrane, c'est-à-dire selon une direction verticale dans l'orientation de la figure 1.

Le transducteur de la figure 1 comprend de plus un actionneur piézoélectrique 105 fixé à la membrane 101, du côté de la face supérieure de la membrane 101 dans l'exemple représenté. Dans cet exemple, l'actionneur piézoélectrique 105 est disposé en vis-à-vis d'une partie centrale de la membrane 101. L'actionneur 105 comprend une première couche conductrice 105a, par exemple une couche métallique, disposée sur la face supérieure de la membrane, une couche piézoélectrique 105b revêtant la face supérieure de la couche 105a, et une deuxième couche conductrice 105c revêtant la face supérieure de la couche piézoélectrique 105b. Les couches conductrices 105c et 105a forment respectivement une première électrode A et une deuxième électrode B de commande de l'actionneur 105, destinées à être connectées à un circuit de commande (non représenté) du transducteur.

L'application d'une tension entre les électrodes A et B de l'actionneur conduit :

- soit à une contraction de la couche piézoélectrique 105b dans la direction du champ électrique appliqué, c'est-à-dire dans une direction orthogonale à la couche 105b, et donc à un étirement de la couche piézoélectrique 105b perpendiculairement au champ électrique, c'est-à-dire parallèlement à la couche 105b ;
- soit à un étirement de la couche piézoélectrique 105b dans la direction du champ électrique appliqué, et donc à une contraction de la couche piézoélectrique 105b perpendiculairement au champ électrique, c'est-à-dire parallèlement à la couche 105b.

Plus particulièrement, un matériau piézoélectrique comprend classiquement une pluralité de dipôles élémentaires orientés dans une direction et un sens privilégiés qui conduisent à l'obtention d'un dipôle électrostatique macroscopique non nul $\vec{P}$ appelé polarisation. Dans l'exemple de la figure 1, la polarisation $\vec{P}$ de la couche piézoélectrique 105b est orthogonale à la couche 105b, le pôle négatif de la couche 105b étant côté face inférieure de la couche 105b et le pôle positif de la couche 105b étant côté face supérieure de la couche 105b. Dans ces conditions, l'application d'une tension positive entre l'électrode A et l'électrode B de l'actionneur piézoélectrique 105 conduit à un étirement de la couche 105b orthogonalement au champ électrique appliqué, c'est-à-dire parallèlement à la membrane 101, conduisant à une déflexion vers le haut (non représentée sur la figure) de la partie centrale de la membrane. L'application d'une tension négative entre l'électrode A et l'électrode B de l'actionneur piézoélectrique 105 conduit au contraire à une contraction de la couche 105b parallèlement à la membrane 101, conduisant à une déflexion vers le bas de la partie centrale de la membrane.

Dans le domaine dit des petites déformations, c'est-à-dire pour des déplacements de la membrane inférieurs à la moitié de son épaisseur, la déflexion de la membrane 101, c'est-à-dire la distance entre le centre de la membrane lorsqu'une tension de commande est appliquée entre les électrodes A et B de l'actionneur, et le centre de la membrane lorsqu'aucune tension de commande n'est appliquée entre les électrodes A et B (en position de repos), est sensiblement proportionnelle à la tension appliquée. Dans le domaine des grandes déformations, c'est-à-dire pour des déplacements de la membrane supérieurs à la moitié de son épaisseur, la relation de proportionnalité n'est plus vérifiée dans la mesure où la raideur de la membrane augmente avec sa déformation.

On cherche ici à réaliser un transducteur piézoélectrique permettant, pour un niveau de tension de commande donné, d'augmenter la déflexion de la membrane, notamment dans le domaine des grandes déformations.

Pour maximiser l'amplitude du déplacement de la membrane pour une tension de commande donnée, une possibilité consiste à choisir le matériau piézoélectrique présentant le coefficient piézoélectrique le plus élevé possible. Pour cette raison, le Titano-Zirconate de Plomb, généralement appelé PZT, est couramment utilisé dans les transducteurs piézoélectriques.

Le PZT a toutefois pour caractéristique d'être ferroélectrique. Ainsi, lorsqu'un champ électrique lui est appliqué, il se repolarise dans la direction du champ appliqué. Il en résulte que dans un transducteur du type décrit en relation avec la figure 1, lorsque la couche piézoélectrique 105b est en PZT ou, plus généralement, en tout autre matériau piézoélectrique ferroélectrique, quelle que soit la polarité de la tension de commande appliquée entre les électrodes A et B, la couche 105b peut uniquement se contracter dans la direction transverse au champ électrique appliqué. Autrement dit, quelle que soit la polarité de la tension de commande appliquée entre les électrodes A et B, le sens de déplacement de la membrane est toujours le même (vers le bas dans l'exemple de la figure 1).

Les matériaux piézoélectriques non ferroélectriques tels que le nitrure d'aluminium (AlN), l'oxyde de zinc (ZnO) ou le polyfluorure de vinylidène (PVDF) ne présentent pas cet effet de repolarisation et peuvent donc se contracter ou s'étirer perpendiculairement au champ électrique appliqué, ce qui permet de déplacer la membrane vers le haut et vers le bas selon la polarité de la tension de commande appliquée entre les électrodes A et B.

La figure 2 est une vue en coupe illustrant de façon schématique un autre exemple d'un transducteur piézoélectrique.

Le transducteur de la figure 2 comprend, comme dans l'exemple de la figure 1, une membrane flexible 101 suspendue sur un support rigide 103, et un actionneur piézoélectrique 105 revêtant une partie centrale de la membrane 101.

Le transducteur de la figure 2 comprend de plus un actionneur piézoélectrique 107 revêtant une partie périphérique de la membrane 101. Dans cet exemple, l'actionneur 107 comprend une première couche conductrice 107a, par exemple une couche métallique, disposée sur la face supérieure de la membrane, une couche piézoélectrique 107b revêtant la face supérieure de la couche 107a, et une deuxième couche conductrice 107c revêtant la face supérieure de la couche piézoélectrique 107b.

Dans cet exemple, la couche conductrice inférieure 105a de l'actionneur 105 et la couche conductrice inférieure 107a de l'actionneur 107 font partie d'une même couche conductrice 109 s'étendant de façon continue sur sensiblement toute la surface supérieure de la membrane 101. De plus, la couche piézoélectrique 105b de l'actionneur 105 et la couche piézoélectrique 107b de l'actionneur 107 font partie d'une même couche piézoélectrique 111 s'étendant de façon continue sur sensiblement toute la surface de la membrane 101. Les couches conductrices supérieures 105c de l'actionneur 105 et 107c de l'actionneur 107 sont en revanche disjointes, ce qui permet une commande différentiée des deux actionneurs.

Les couches conductrices 105c, 107c et 109 forment respectivement une première électrode A, une deuxième électrode B et une troisième électrode C de commande du transducteur, destinées à être connectées à un circuit de commande (non représenté) du transducteur.

Dans le cas où la couche 111 est en un matériau piézoélectrique ferroélectrique, par exemple du PZT, l'actionneur 105 est utilisé pour commander le déplacement de la membrane dans un premier sens (vers le bas dans l'exemple de la figure 2), et l'actionneur 107 est utilisé pour commander le déplacement de la membrane dans l'autre sens (vers le haut dans cet exemple). Plus particulièrement, le transducteur de la figure 2 peut être commandé dans une première configuration dans laquelle une tension non nulle (positive ou négative) est appliquée entre les électrodes A et C et une tension sensiblement nulle est appliquée entre les électrodes B et C, et dans une deuxième configuration dans laquelle une tension non nulle (positive ou négative) est appliquée entre les électrodes B et C et une tension sensiblement nulle est appliquée entre les électrodes A et C. Dans la première configuration, la tension appliquée entre les électrodes A et C provoque une contraction de la couche 105b perpendiculairement à la membrane 101, et donc une déflexion vers le bas de la membrane 101. Dans la deuxième configuration, la tension appliquée entre les électrodes B et C provoque une contraction de la couche 107b perpendiculairement à la membrane 101, et donc une déflexion vers le haut de la membrane 101.

Dans le cas où la couche 111 est en un matériau piézoélectrique non ferroélectrique tel que l'AlN, des tensions de polarités opposées peuvent être appliquées simultanément entre les électrodes A et C d'une part et entre les électrodes B et C d'autre part de façon à maximiser l'amplitude des déplacements de la membrane. Plus particulièrement, le transducteur de la figure 2 peut être commandé dans une première configuration dans laquelle une tension positive est appliquée entre les électrodes A et C et une tension négative est appliquée entre les électrodes B et C, et dans une deuxième configuration dans laquelle une tension négative est appliquée entre les électrodes A et C et une tension positive est appliquée entre les électrodes B et C. Dans le cas d'une couche piézoélectrique 111 de polarisation $\vec{P}$ orthogonale à la couche 111, dont le pôle négatif est situé côté face inférieure de la couche 111 et dont le pôle positif est situé côté face supérieure de la couche 111, on obtient, dans la première configuration, un déplacement vers le haut de la membrane 101, et, dans la deuxième configuration, un déplacement vers le bas de la membrane 101.

La figure 3 est une vue en coupe illustrant de façon schématique un autre exemple d'un transducteur piézoélectrique.

Le transducteur de la figure 3 est de type bimorphe, c'est-à-dire qu'il comporte deux couches piézoélectriques actives (par opposition aux transducteurs de type unimorphe comportant une seule couche piézoélectrique active tels que décrits en relation avec les figures 1 et 2). Dans ce cas, la couche flexible 101 des exemples des figures 1 et 2, ayant une fonction purement mécanique (couche passive), peut être retirée.

Le transducteur de la figure 3 diffère des transducteurs décrits en relation avec les figures 1 et 2 en ce que, dans l'exemple de la figure 3, la membrane flexible passive 101 des exemples des figures 1 et 2 est remplacée par une membrane flexible active 301. La membrane 301 est suspendue sur un support rigide 103 de façon similaire à ce qui a été décrit dans les exemples précédents.

La membrane 301 comprend un empilement vertical comprenant, dans l'ordre à partir de la face inférieure de la membrane, une première couche conductrice 311, par exemple une couche métallique, une première couche piézoélectrique non ferroélectrique 313, par exemple en AlN, en ZnO, en PVDF, ou en tout autre matériau piézoélectrique non ferroélectrique, une deuxième couche conductrice 315, par exemple une couche métallique, une deuxième couche piézoélectrique non ferroélectrique 317, et une troisième couche conductrice 319, par exemple une couche métallique. Les couches piézoélectriques 313 et 317 sont par exemple en le même matériau. De même, les couches conductrices 311, 315 et 319 peuvent être en le même matériau.

Dans cet exemple, les couches piézoélectriques 313 et 317 et la couche conductrice intermédiaire 315 sont des couches continues s'étendant sur sensiblement toute la surface de la membrane. Les couches conductrices inférieure 311 et supérieure 319 sont quant à elles discontinues. Plus particulièrement, la couche 311 est discrétisée de façon à définir une première électrode inférieure B dans une partie centrale de la membrane 301, et une deuxième électrode inférieure D dans une partie périphérique de la membrane 301. De façon similaire, la couche 319 est discrétisée de façon à définir une première électrode supérieure A dans une partie centrale de la membrane 301 et une deuxième électrode supérieure C dans une partie périphérique de la membrane 301. Dans cet exemple, l'électrode A est située à l'aplomb de l'électrode B et l'électrode C est située à l'aplomb de l'électrode D.

Ainsi, la membrane 301 du transducteur piézoélectrique de la figure 3 intègre quatre actionneurs piézoélectriques définis comme suit :

- un actionneur central supérieur comprenant l'électrode A, la portion de la couche piézoélectrique 317 située à l'aplomb de l'électrode A, et la portion de la couche conductrice 315 située à l'aplomb de l'électrode A ;
- un actionneur périphérique supérieur comprenant l'électrode C, la portion de la couche piézoélectrique 317 située à l'aplomb de l'électrode C, et la portion de la couche conductrice 315 située à l'aplomb de l'électrode C ;
- un actionneur central inférieur comprenant l'électrode B, la portion de la couche piézoélectrique 313 située à l'aplomb de l'électrode B, et la portion de la couche conductrice 315 située à l'aplomb de l'électrode B ; et
- un actionneur périphérique inférieur comprenant l'électrode D, la portion de la couche piézoélectrique 313 située à l'aplomb de l'électrode D, et la portion de la couche conductrice 315 située à l'aplomb de l'électrode D.

Dans cet exemple, les couches piézoélectriques 313 et 317 ont la même direction et le même sens de polarisation $\vec{P}$. Plus particulièrement, dans l'exemple représenté, le pôle négatif de la couche 313 est situé côté face inférieure de la couche 313, le pôle positif de la couche 313 est situé côté face supérieure de la couche 313, le pôle négatif de la couche 317 est situé côté face inférieure de la couche 317 et le pôle positif de la couche 317 est situé côté face supérieure de la couche 317.

Les électrodes A, B, C et D ainsi que l'électrode centrale formée par la couche conductrice intermédiaire 315 sont destinées à être connectées à un circuit de commande (non représenté) du transducteur. Dans cet exemple, les tensions de commande appliquées sur les électrodes A, B, C et D du transducteur sont toutes référencées par rapport à l'électrode centrale formée par la couche 315.

La figure 4 est un chronogramme illustrant un exemple d'un procédé de commande du transducteur piézoélectrique de la figure 3. Le document JP H03 54383 montre un transducteur piézoélectrique de type bimorphe tel que décrit dans la figure 3 et qui est commandé par ce procédé de commande. La figure 4 représente plus particulièrement l'évolution, en fonction du temps (en abscisse), des tensions de commande $V_A$, $V_B$, $V_C$ et $V_D$ (en ordonnée) appliquées respectivement sur les électrodes A, B, C et D du transducteur par le circuit de commande (non représenté) du transducteur. Comme indiqué précédemment, les tensions de commande $V_A$, $V_B$, $V_C$ et $V_D$ sont toutes référencées par rapport à l'électrode centrale 315 du transducteur. A titre d'exemple, l'électrode centrale est connectée à un noeud GND d'application d'un potentiel de référence du circuit de commande, par exemple un potentiel de 0 V, par exemple la masse.

Dans cet exemple, le circuit de commande du transducteur est configuré pour commander le transducteur dans l'une ou l'autre de première et deuxième configurations, correspondant respectivement à la phase P1 et à la phase P2 du chronogramme de la figure 4.

Dans la première configuration (phase P1), une tension positive V+ est appliquée sur l'électrode A, une tension positive, par exemple de même niveau V+, est appliquée sur l'électrode B, une tension négative V- est appliquée sur l'électrode C, et une tension négative, par exemple de même niveau V-, est appliquée sur l'électrode D.

Dans la deuxième configuration (phase P2), une tension négative V- est appliquée sur l'électrode A, une tension négative, par exemple de même niveau V-, est appliquée sur l'électrode B, une tension positive V+ est appliquée sur l'électrode C, et une tension positive, par exemple de même niveau V+, est appliquée sur l'électrode D.

Dans la première configuration, on obtient, dans la direction orthogonale à la membrane 301, un étirement de la couche piézoélectrique 317 dans sa partie centrale (en vis-à-vis de l'électrode A), une contraction de la couche piézoélectrique 317 dans sa partie périphérique (en vis-à-vis de l'électrode C), une contraction de la couche piézoélectrique 313 dans sa partie centrale (en vis-à-vis de l'électrode B) et un étirement de la couche piézoélectrique 313 dans sa partie périphérique (en vis-à-vis de l'électrode D). Il en résulte un déplacement vers le haut de la membrane 301.

Dans la deuxième configuration, on obtient, dans la direction orthogonale à la membrane 301, une contraction de la couche piézoélectrique 317 dans sa partie centrale (en vis-à-vis de l'électrode A), un étirement de la couche piézoélectrique 317 dans sa partie périphérique (en vis-à-vis de l'électrode C), un étirement de la couche piézoélectrique 313 dans sa partie centrale (en vis-à-vis de l'électrode B), et une contraction de la couche piézoélectrique 313 dans sa partie périphérique (en vis-à-vis de l'électrode D). Il en résulte un déplacement vers le bas de la membrane 301.

Le transducteur de la figure 3 combiné avec le mode de commande de la figure 4 permet d'atteindre des déflexions de la membrane d'amplitudes plus importantes que celles qui peuvent être obtenues avec des transducteurs du type décrit en relation avec les figures 1 et 2.

De façon surprenante, les inventeurs ont toutefois constaté que dans un transducteur du type décrit en relation avec la figure 3, il est possible d'obtenir des amplitudes de déflexion encore plus importantes en activant uniquement les actionneurs produisant un étirement de la couche piézoélectrique, à savoir, dans l'exemple décrit ci-dessus, l'actionneur central supérieur et l'actionneur périphérique inférieur dans la première configuration, et l'actionneur central inférieur et l'actionneur périphérique supérieur dans la deuxième configuration, et en désactivant (c'est-à-dire en maintenant au repos) les autres actionneurs, à savoir, dans l'exemple décrit ci-dessus, l'actionneur central inférieur et l'actionneur périphérique supérieur dans la première configuration et l'actionneur central supérieur et l'actionneur périphérique inférieur dans la deuxième configuration.

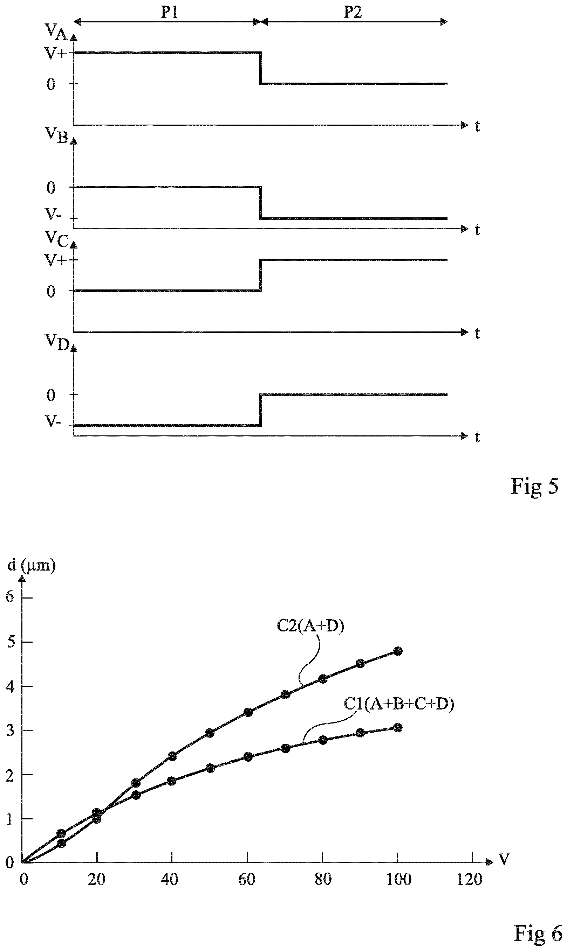

La figure 5 est un chronogramme illustrant un exemple d'un procédé de commande d'un transducteur piézoélectrique selon un mode de réalisation. On considère ici un transducteur du type décrit en relation avec la figure 3. La figure 5 représente l'évolution, en fonction du temps (en abscisse), des tensions de commande $V_A$, $V_B$, $V_C$ et $V_D$ (en ordonnée) appliquées respectivement sur les électrodes A, B, C et D du transducteur par le circuit de commande (non représenté) du transducteur. Comme précédemment, les tensions de commande $V_A$, $V_B$, $V_C$ et $V_D$ sont toutes référencées par rapport à l'électrode centrale 315 du transducteur. A titre d'exemple, l'électrode centrale est connectée à un noeud GND d'application d'un potentiel de référence du circuit de commande, par exemple un potentiel de 0 V, par exemple la masse.

Dans cet exemple, le circuit de commande du transducteur est configuré pour commander le transducteur dans l'une ou l'autre de première et deuxième configurations, correspondant respectivement à la phase P1 et à la phase P2 du chronogramme de la figure 5.

Dans la première configuration (phase P1), une tension positive V+ est appliquée sur l'électrode A, une tension sensiblement nulle est appliquée sur l'électrode B, une tension sensiblement nulle est appliquée sur l'électrode C, et une tension négative V- est appliquée sur l'électrode D. Par tension sensiblement nulle, on entend ici une tension proche de la tension de référence du noeud GND, par exemple égale à plus ou moins 10 mV près à la tension de référence du noeud GND. Les tensions positive V+ et négative V- sont quant à elles d'un niveau apte à provoquer une déformation significative de la couche piézoélectrique dans l'actionneur correspondant. A titre d'exemple, les tensions V+ et V- sont supérieures à 5 V en valeur absolue. Les tensions V+ et V- sont par exemple sensiblement égales en valeur absolue.

Dans la deuxième configuration (phase P2), une tension sensiblement nulle est appliquée sur l'électrode A, une tension négative V- est appliquée sur l'électrode B, une tension positive V+ est appliquée sur l'électrode C, et une tension sensiblement nulle est appliquée sur l'électrode D.

Dans la première configuration, on obtient, dans la direction orthogonale à la membrane 301, un étirement de la couche piézoélectrique 317 dans sa partie centrale (en vis-à-vis de l'électrode A), et un étirement de la couche piézoélectrique 313 dans sa partie périphérique (en vis-à-vis de l'électrode D). Il en résulte un déplacement vers le haut de la membrane 301. La couche piézoélectrique 317 reste en revanche au repos dans sa partie périphérique (en vis-à-vis de l'électrode C), et la couche piézoélectrique 313 reste au repos dans sa partie centrale (en vis-à-vis de l'électrode B). Comme l'illustre la figure 6 détaillée ci-après, ceci permet, par rapport au mode de commande décrit précédemment dans lequel l'actionneur périphérique supérieur et l'actionneur central inférieur sont activés en contraction, d'augmenter encore la déflexion de la membrane, notamment dans le domaine des grandes déformations.

Dans la deuxième configuration, on obtient, dans la direction orthogonale à la membrane 301, un étirement de la couche piézoélectrique 317 dans sa partie périphérique (en vis-à-vis de l'électrode C), et un étirement de la couche piézoélectrique 313 dans sa partie centrale (en vis-à-vis de l'électrode B). Il en résulte un déplacement vers le bas de la membrane 301. La couche piézoélectrique 317 reste en revanche au repos dans sa partie centrale (en vis-à-vis de l'électrode A), et la couche piézoélectrique 313 reste au repos dans sa partie périphérique (en vis-à-vis de l'électrode D). Là encore, ceci permet, par rapport au mode de commande décrit précédemment dans lequel l'actionneur périphérique inférieur et l'actionneur central supérieur sont activés en contraction, d'augmenter la déflexion de la membrane, notamment dans le domaine des grandes déformations.

La figure 6 est un diagramme illustrant un avantage du mode de commande décrit en relation avec la figure 5 par rapport au mode de commande décrit en relation avec la figure 4. Le diagramme de la figure 6 représente l'évolution du déplacement d de la membrane en son centre et selon une direction orthogonale à la membrane (en ordonnée, en micromètres), en fonction du niveau de tension V (en abscisse, en volts) appliqué sur les électrodes de commande du transducteur (avec, dans cet exemple, V=|V+|=|V-|). Le diagramme de la figure 6 comprend plus particulièrement deux courbes C1 et C2. La courbe C1 représente l'évolution du déplacement de la membrane en fonction du niveau de tension de commande lorsque le transducteur est commandé dans la première configuration (P1) du procédé de commande de la figure 4, c'est-à-dire lorsque les quatre actionneurs définis respectivement par les électrodes A, B, C et D sont activés en combinaison pour générer un déplacement vers le haut de la membrane 301. La courbe C2 représente l'évolution du déplacement de la membrane en fonction du niveau de tension de commande lorsque le transducteur est commandé dans la première configuration (P1) du procédé de commande de la figure 5, c'est-à-dire lorsque seuls les actionneurs A et D sont activés pour générer un déplacement vers le haut de la membrane 301.

Comme cela apparaît sur la figure 6, jusqu'à une certaine amplitude de déplacement de la membrane, de l'ordre de 1 μm dans cet exemple (correspondant dans cet exemple à un niveau de tension de commande de l'ordre de 5 V), le déplacement de la membrane est sensiblement proportionnel au niveau V de tension de commande appliqué au transducteur (et du nombre d'actionneurs sollicités). Cette plage de fonctionnement correspond au domaine dit des petites déformations. Dans ce domaine de fonctionnement, le procédé de commande de la figure 4 (courbe C1) est environ deux fois plus efficace que le procédé de commande de la figure 5 (courbe C2).

Pour des déformations plus importantes de la membrane, le déplacement d de la membrane n'est plus proportionnel au niveau de tension de commande V appliqué. Cette plage de fonctionnement correspond au domaine dit des grandes déformations. De façon surprenante, on observe que, dans ce domaine de fonctionnement, pour un niveau de tension de commande V suffisamment important (pour un niveau de tension de commande V supérieur à environ 20 V dans l'exemple représenté), la déflexion de la membrane 301 est significativement plus importante lorsque le transducteur est commandé selon le procédé de la figure 5 que lorsque le transducteur est commandé selon le procédé de la figure 4. Bien que les courbes correspondantes n'aient pas été représentées sur la figure 6, un avantage similaire est obtenu lorsque le transducteur est commandé dans la deuxième configuration (phases P2 des procédés de commande des figures 4 et 5, conduisant à un déplacement vers le bas de la membrane 301).

On notera que dans l'exemple de la figure 5, les tensions de commande appliquées au transducteur dans les première et deuxième configurations sont des tensions continues. Une commande à tension continue peut par exemple être utilisée pour réaliser un actionneur électromécanique, par exemple pour l'actionnement d'une micro-pompe, d'une micro-vanne, d'un micro-miroir mobile, etc.

Les modes de réalisation décrits ne se limitent toutefois pas à ce cas particulier. A titre de variante, les tensions de commande appliquées au transducteur peuvent être des tensions variables. Une commande à tension variable peut par exemple être utilisée pour réaliser un générateur d'ondes acoustiques, par exemple pour des applications d'écholocalisation, de contrôle non destructif par ultrasons, ou encore pour réaliser un haut-parleur.

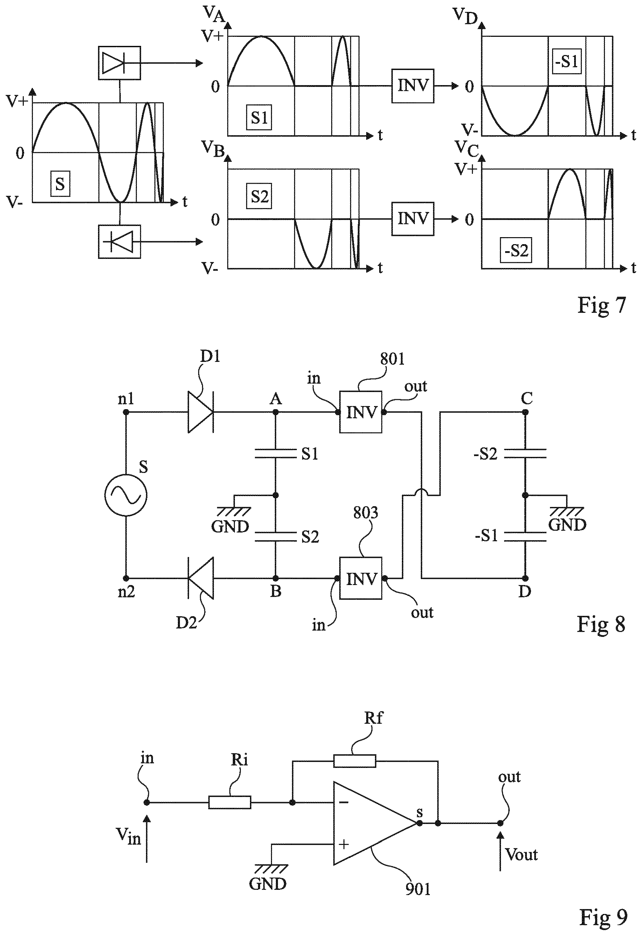

La figure 7 illustre un exemple d'un procédé de commande d'un transducteur piézoélectrique selon un mode de réalisation. On considère ici un transducteur du type décrit en relation avec la figure 3. Dans cet exemple, les tensions de commande appliquées au transducteur sont des tensions variables.

La figure 7 comprend, en partie gauche, un diagramme représentant une tension de commande de base S représentative du déplacement que l'on souhaite appliquer à la membrane. La tension S est une tension alternative alternant entre une valeur crête positive V+ et une valeur crête négative V-. La tension S est référencée par rapport à l'électrode intermédiaire 315 du transducteur.

La figure 7 comprend en outre, en partie droite, quatre diagrammes représentant respectivement les tensions $V_A$, $V_B$, $V_C$ et $V_D$ appliquées sur les électrodes A, B, C et D du transducteur.

On prévoit ici, dans les phases positives de la tension de commande S, d'activer uniquement l'actionneur central supérieur et l'actionneur périphérique inférieur de la membrane 301, et, dans les phases négatives de la tension de commande S, d'activer uniquement l'actionneur périphérique supérieur et l'actionneur central inférieur de la membrane 301.

Plus particulièrement, dans cet exemple, on applique :

- sur l'électrode A, une tension de commande $V_A$ = S1 sensiblement égale à la tension S dans les phases positives de la tension S, et sensiblement nulle dans les phases négatives de la tension S ;
- sur l'électrode B, une tension de commande $V_B$ = S2 sensiblement égale à la tension S dans les phases négatives de la tension S, et sensiblement nulle dans les phases positives de la tension S ;
- sur l'électrode D, une tension de commande $V_D$ = -S1 ; et
- sur l'électrode C, une tension de commande $V_C$ = -S2.

A titre d'exemple, la tension S1 (électrode A) est générée à partir de la tension S au moyen d'un redresseur simple alternance, la tension S2 (électrode B) est générée à partir de la tension S au moyen d'un redresseur simple alternance retourné, la tension -S1 (électrode D) est générée au moyen d'un inverseur de polarité à partir de la tension S1, et la tension -S2 (électrode C) est générée au moyen d'un inverseur de polarité à partir de la tension S2.

La figure 8 est un schéma électrique simplifié d'un circuit de commande d'un transducteur piézoélectrique, adapté à mettre en oeuvre le procédé de commande de la figure 7.

Le circuit de commande de la figure 8 comprend des noeuds d'entrée n1 et n2 entre lesquels est appliquée la tension de commande de base S, référencée par rapport au noeud GND (connecté à l'électrode intermédiaire 315 du transducteur). Le circuit de commande de la figure 8 comprend en outre une diode D1 montée en direct entre le noeud n1 et l'électrode A du transducteur, et une diode D2 montée en inverse entre le noeud n2 et l'électrode B du transducteur. Plus particulièrement, dans cet exemple, la diode D1 a son anode connectée au noeud n1 et sa cathode connectée à l'électrode A, et la diode D2 a son anode connectée à l'électrode B et sa cathode connectée au noeud n2. Le circuit de commande de la figure 8 comprend en outre un premier circuit d'inversion de polarité 801 (INV) dont un noeud d'entrée in est relié, par exemple connecté, à l'électrode A et dont un noeud de sortie out est relié, par exemple connecté, à l'électrode D, et un deuxième circuit d'inversion de polarité 803 (INV), par exemple identique au circuit 801, dont un noeud d'entrée in est relié, par exemple connecté, à l'électrode B et dont un noeud de sortie est relié, par exemple connecté, à l'électrode C.

Ainsi, le circuit de commande de la figure 8 permet, à partir de la tension de commande de base S, de générer la tension de commande S1 appliquée sur l'électrode A, la tension de commande S2 appliquée sur l'électrode B, la tension de commande -S1 appliquée sur l'électrode D, et la tension de commande -S2 appliquée sur l'électrode C.

La figure 9 est un schéma électrique d'un exemple de réalisation du circuit d'inversion de polarité 801 ou 803 du circuit de commande de la figure 8. Dans cet exemple, le circuit d'inversion de polarité comprend un amplificateur opérationnel 901 dont l'entrée positive (+) est reliée, par exemple connectée, au noeud GND, et dont l'entrée négative (-) est reliée au noeud d'entrée in du circuit par l'intermédiaire d'une résistance Ri. Le circuit de la figure 9 comprend de plus une résistance Rf reliant le noeud de sortie s de l'amplificateur opérationnel à son entrée négative (-). Le noeud de sortie out du circuit d'inversion de polarité est relié, par exemple connecté, au noeud de sortie s de l'amplificateur opérationnel.

La tension de sortie Vout du circuit de la figure 9 s'exprime en fonction de la tension d'entrée Vin, du gain G de l'amplificateur, de la résistance d'entrée Ri, et de la résistance de contre-réaction Rf, comme suit :

$$Vout = -\frac{Rf * Vin * G}{Rf + Ri * (1 + G)}$$

En considérant une valeur de gain G suffisamment élevée, cette équation peut être simplifiée comme suit :

$$Vout = -\frac{Rf * Vin}{Ri}$$

En prenant des valeurs de résistances Ri et Rf sensiblement égales, on a bien Vout=-Vin.

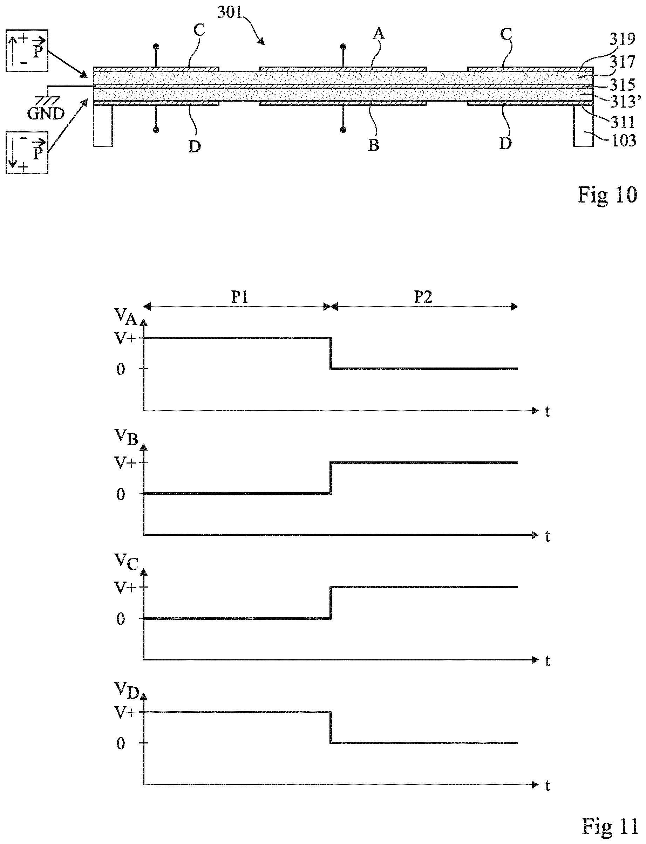

La figure 10 est une vue en coupe d'une variante de réalisation d'un transducteur piézoélectrique. Le transducteur de la figure 10 est identique ou similaire au transducteur 301 de la figure 3, à la différence près que, dans l'exemple de la figure 10, la couche piézoélectrique inférieure 313 du transducteur de la figure 3 est remplacée par une couche piézoélectrique 313' similaire à la couche 313 mais de polarisation $\vec{P}$ inversée par rapport à la couche 313.

Ainsi, dans l'exemple de la figure 10, les couches piézoélectriques 313' et 317 ont la même direction de polarisation, orthogonale à la membrane, mais des sens de polarisation opposés. Plus particulièrement, dans l'exemple représenté, le pôle positif de la couche 313' est situé côté face inférieure de la couche 313', le pôle négatif de la couche 313' est situé côté face supérieure de la couche 313', le pôle négatif de la couche 317 est situé côté face inférieure de la couche 317 et le pôle positif de la couche 317 est situé côté face supérieure de la couche 317.

La figure 11 est un chronogramme illustrant un exemple d'un mode de réalisation d'un procédé de commande du transducteur piézoélectrique de la figure 10. La figure 11 représente l'évolution, en fonction du temps (en abscisse), des tensions de commande $V_A$, $V_B$, $V_C$ et $V_D$ (en ordonnée) appliquées respectivement sur les électrodes A, B, C et D du transducteur par le circuit de commande (non représenté) du transducteur. Comme précédemment, les tensions de commande $V_A$, $V_B$, $V_C$ et $V_D$ sont toutes référencées par rapport à l'électrode centrale 315 du transducteur, reliée à un noeud GND d'application d'un potentiel de référence du circuit de commande.

Dans cet exemple, le circuit de commande du transducteur est configuré pour commander le transducteur dans l'une ou l'autre de première et deuxième configurations, correspondant respectivement à la phase P1 et à la phase P2 du chronogramme de la figure 5.

Dans la première configuration (phase P1), une tension positive V+ est appliquée sur l'électrode A, une tension sensiblement nulle est appliquée sur l'électrode B, une tension sensiblement nulle est appliquée sur l'électrode C, et une tension positive V+ est appliquée sur l'électrode D.

Dans la deuxième configuration (phase P2), une tension sensiblement nulle est appliquée sur l'électrode A, une tension positive V+ est appliquée sur l'électrode B, une tension positive V+ est appliquée sur l'électrode C, et une tension sensiblement nulle est appliquée sur l'électrode D.

Dans la première configuration, on obtient, dans la direction orthogonale à la membrane 301, un étirement de la couche piézoélectrique 317 dans sa partie centrale (en vis-à-vis de l'électrode A), et un étirement de la couche piézoélectrique 313' dans sa partie périphérique (en vis-à-vis de l'électrode D). Il en résulte un déplacement vers le haut de la membrane 301. La couche piézoélectrique 317 reste en revanche au repos dans sa partie périphérique (en vis-à-vis de l'électrode C), et la couche piézoélectrique 313' reste au repos dans sa partie centrale (en vis-à-vis de l'électrode B). Comme dans l'exemple de la figure 5, ceci permet, par rapport à un mode de commande dans lequel l'actionneur périphérique supérieur et l'actionneur central inférieur sont activés en contraction, d'augmenter la déflexion de la membrane, notamment dans le domaine des grandes déformations.

Dans la deuxième configuration, on obtient, dans la direction orthogonale à la membrane 301, un étirement de la couche piézoélectrique 317 dans sa partie périphérique (en vis-à-vis de l'électrode C), et un étirement de la couche piézoélectrique 313' dans sa partie centrale (en vis-à-vis de l'électrode B). Il en résulte un déplacement vers le bas de la membrane 301. La couche piézoélectrique 317 reste en revanche au repos dans sa partie centrale (en vis-à-vis de l'électrode A), et la couche piézoélectrique 313' reste au repos dans sa partie périphérique (en vis-à-vis de l'électrode D). Là encore, ceci permet, par rapport à un mode de commande dans lequel l'actionneur périphérique inférieur et l'actionneur central supérieur sont activés en contraction, d'augmenter la déflexion de la membrane, notamment dans le domaine des grandes déformations.

A titre de variante, le transducteur de la figure 10 peut être commandé par une tension variable de façon similaire à ce qui a été décrit en relation avec la figure 7. Dans ce cas, la tension positive S1 est appliquée sur l'électrode A et sur l'électrode D, et la tension négative S2 est appliquée sur l'électrode B et sur l'électrode C, ce qui permet de simplifier le circuit de commande. En particulier, les circuits d'inversion de polarité 801 et 803 du circuit de commande de la figure 8 peuvent alors être omis.

Des modes de réalisation particuliers ont été décrits. Diverses variantes et modifications apparaîtront à l'homme de l'art. En particulier, les modes de réalisation décrits ne se limitent pas aux exemples de formes de membrane et de disposition des actionneurs décrits ci-dessus.

## Revendications

1.    Transducteur piézoélectrique comportant :

       une première couche piézoélectrique (313 ; 313') en un matériau non ferroélectrique, la première couche ayant une face avant et une face arrière ;
       une première couche conductrice (315) disposée sur la face avant de la première couche piézoélectrique (313 ; 313') ;
       une deuxième couche piézoélectrique (317) en un matériau non ferroélectrique disposée sur la face avant de la première couche conductrice (315) ;
       une première électrode (A) disposée sur la face avant de la deuxième couche piézoélectrique (317) ;
       une deuxième électrode (B) disposée sur la face arrière de la première couche piézoélectrique (313 ; 313'), en vis à vis de la première électrode (A) ;
       une troisième électrode (C) disposée sur la face avant de la deuxième couche piézoélectrique (317) ;
       une quatrième électrode (D) disposée sur la face arrière de la première couche piézoélectrique (317), en vis-à-vis de la troisième électrode (C) ; et
       un circuit de commande configuré pour :

             dans une première phase de fonctionnement, appliquer simultanément une tension ($V_A$ ; S1) non nulle sur la première électrode (A), une tension ($V_D$ ; -S1) non nulle sur la quatrième électrode (D), et des tensions

($V_B$, $V_C$ ; S2, -S2) sensiblement nulles sur les deuxième (B) et troisième (C) électrodes ; et

dans une deuxième phase de fonctionnement, appliquer simultanément une tension ($V_B$ ; S2) non nulle sur la deuxième électrode (B), une tension ($V_C$ ; -S2) non nulle sur la troisième électrode (C), et des tensions ($V_A$, $V_D$ ; S1, -S1) sensiblement nulles sur les première (A) et quatrième (D) électrodes.

2. Transducteur selon la revendication 1, dans lequel les première (313) et deuxième (317) couches piézoélectriques ont des polarisations $\vec{P}$ identiques, et dans lequel le circuit de commande est configuré pour, dans la première configuration, appliquer des tensions de polarité opposées sur les première (A) et quatrième (D) électrodes, et, dans la deuxième configuration, appliquer des tensions de polarité opposées sur les deuxième (B) et troisième (C) électrodes.

3. Transducteur selon la revendication 2, dans lequel les première (313) et deuxième (317) couches piézoélectrique ont chacune un pôle négatif du côté de leur face arrière et un pôle positif du côté de leur face avant, et dans lequel le circuit de commande est configuré pour, dans la première configuration, appliquer une tension positive sur la première (A) électrode et une tension négative sur la quatrième (D) électrode, et, dans la deuxième configuration, appliquer une tension négative sur la deuxième (B) électrode et une tension positive sur la troisième (C) électrode.

4. Transducteur selon la revendication 1, dans lequel les première (313') et deuxième (317) couches piézoélectriques ont des polarisations $\vec{P}$ opposées, et dans lequel le circuit de commande est configuré pour, dans la première configuration, appliquer des tensions de même polarité sur les première (A) et quatrième (D) électrodes, et, dans la deuxième configuration, appliquer des tensions de même polarité sur les deuxième (B) et troisième (C) électrodes.

5. Transducteur selon la revendication 4, dans lequel la première couche piézoélectrique (313') a un pôle positif du côté de sa face arrière et un pôle négatif du côté de sa face avant, et la deuxième couche piézoélectrique (317) a un pôle négatif du côté de sa face arrière et un pôle positif du côté de sa face avant, et dans lequel le circuit de commande est configuré pour, dans la première configuration, appliquer une tension positive sur la première (A) électrode et une tension positive sur la quatrième (D) électrode, et, dans la deuxième configuration, appliquer une tension positive sur la deuxième (B) électrode et une tension positive sur la troisième (C) électrode.

6. Transducteur selon l'une quelconque des revendications 1 à 5, dans lequel le circuit de commande est configuré pour, dans la première configuration, appliquer des tensions continues sur les première (A) et quatrième (D) électrodes, et, dans la deuxième configuration, appliquer des tensions continues sur les deuxième (B) et troisième (C) électrodes.

7. Transducteur selon l'une quelconque des revendications 1 à 5, dans lequel le circuit de commande est configuré pour, dans la première configuration, appliquer des tensions variables sur les première (A) et quatrième (D) électrodes, et, dans la deuxième configuration, appliquer des tensions variables sur les deuxième (B) et troisième (C) électrodes.

8. Transducteur selon la revendication 7, dans lequel le circuit de commande comprend :

des premier (n1) et deuxième (n2) noeuds d'application d'une tension de commande alternative (S) ;
une première diode (D1) montée en direct entre le premier noeud (n1) et la première électrode (A) ; et
une deuxième diode (D2) montée en inverse entre le deuxième noeud (n2) et la deuxième électrode (B).

9. Transducteur selon la revendication 8, dans lequel le circuit de commande comprend en outre un premier circuit d'inversion de polarité (801) reliant la première électrode (A) à la quatrième électrode (D), et un deuxième circuit d'inversion de polarité (803) reliant la deuxième électrode (B) à la troisième électrode (C).

10. Transducteur selon l'une quelconque des revendications 1 à 9, dans lequel l'empilement comprenant les première (313 ; 313') et deuxième (317) couches piézoélectriques et la première couche conductrice (315) forme une membrane (301) suspendue sur un support rigide (103).

11. Transducteur selon la revendication 10, dans lequel les première (A) et deuxième (B) électrodes sont disposées en vis-à-vis d'une partie centrale de la membrane (301), et dans lequel les troisième (C) et quatrième (D) électrodes sont disposées en vis-à-vis d'une partie périphérique de la membrane (301).

12. Transducteur selon l'une quelconque des revendications 1 à 11, dans lequel les tensions appliquées par le circuit de commande sur les première (A), deuxième (B), troisième (C) et quatrième (D) électrodes sont référencées par rapport à la première couche conductrice (315).

13. Procédé de commande d'un transducteur piézoélectrique comportant :

une première couche piézoélectrique (313 ; 313') en un matériau non ferroélectrique, la première couche ayant une face avant et une face arrière ;
une première couche conductrice (315) disposée sur la face avant de la première couche piézoélectrique (313 ; 313') ;
une deuxième couche piézoélectrique (317) en un matériau non ferroélectrique disposée sur la face avant de la première couche conductrice (315) ;
une première électrode (A) disposée sur la face avant de la deuxième couche piézoélectrique (317) ;
une deuxième électrode (B) disposée sur la face arrière de la première couche piézoélectrique (313 ; 313'), en vis à vis de la première électrode (A) ;
une troisième électrode (C) disposée sur la face avant de la deuxième couche piézoélectrique (317) ; et
une quatrième électrode (D) disposée sur la face arrière de la première couche piézoélectrique (317), en vis-à-vis de la troisième électrode (C), ce procédé comportant :

dans une première phase de fonctionnement, appliquer simultanément une tension $(V_A$ ; S1) non nulle sur la première électrode (A), une tension $(V_D$ ; -S1) non nulle sur la quatrième électrode (D), et des tensions $(V_B, V_C$ ; S2 ; -S2) sensiblement nulles sur les deuxième (B) et troisième (C) électrodes ; et
dans une deuxième phase de fonctionnement, appliquer simultanément une tension $(V_B$ ; S2) non nulle sur la deuxième électrode (B), une tension $(V_C$ ; -S2) non nulle sur la troisième électrode (C), et des tensions $(V_A, V_D$ ; S1, -S1) sensiblement nulles sur les première (A) et quatrième (D) électrodes.

**Patentansprüche**

1. Piezoelektrischer Wandler der Folgendes aufweist:

eine erste piezoelektrische Schicht (313; 313') aus einem nicht-ferroelektrischen Material, wobei die erste Schicht eine Vorderseite und eine Rückseite aufweist;

eine erste leitende Schicht (315), die auf der Vorderseite der ersten piezoelektrischen Schicht (313; 313') angeordnet ist;
eine zweite piezoelektrische Schicht (317) aus einem nicht-ferroelektrischen Material, die auf der Vorderseite der ersten leitenden Schicht (315) angeordnet ist;
eine erste Elektrode (A), die auf der Vorderseite der zweiten piezoelektrischen Schicht (317) angeordnet ist;
eine zweite Elektrode (B), die auf der Rückseite der ersten piezoelektrischen Schicht (313; 313') gegenüber der ersten Elektrode (A) angeordnet ist;
eine dritte Elektrode (C), die auf der Vorderseite der zweiten piezoelektrischen Schicht (317) angeordnet ist;
eine vierte Elektrode (D), die auf der Rückseite der ersten piezoelektrischen Schicht (317) gegenüber der dritten Elektrode (C) angeordnet ist; und
eine Steuerschaltung, die konfiguriert ist, um:

in einer ersten Betriebsphase gleichzeitig eine Nicht-Nullspannung $(V_A$; S1) an die erste Elektrode (A), eine Nicht-Nullspannung $(V_D$; -S1) an die vierte Elektrode (D) und im Wesentlichen Nullspannungen $(V_B, V_C$; S2, -S2) an die zweiten (B) und dritten (C) Elektroden anzulegen; und
in einer zweiten Betriebsphase gleichzeitig eine Nicht-Nullspannung $(V_B$; S2) an die zweite Elektrode (B), eine Nicht-Nullspannung $(V_C$; -S2) an die dritte Elektrode (C) und im wesentlichen Nullspannungen $(V_A, V_D$; S1, -S1) an die ersten (A) und vierten (D) Elektroden anzulegen.

2. Wandler nach Anspruch 1, wobei die erste (313) und die zweite (317) piezoelektrischen Schichten identische Polarisationen $\vec{P}$ aufweisen und wobei die Steuerschaltung konfiguriert ist, um in der ersten Konfiguration Spannungen entgegengesetzter Polaritäten an die ersten (A) und die vierten (D) Elektroden anzulegen und in der zweiten Konfiguration Spannungen entgegengesetzter Polaritäten an die zweiten (B) und die dritten (C) Elektroden anzulegen.

3. Wandler nach Anspruch 2, wobei die ersten (313) und die zweiten (317) piezoelektrische Schichten jeweils einen negativen Pol auf ihrer Rückseite und einen positiven Pol auf ihrer Vorderseite aufweisen, und wobei die Steuerschaltung konfiguriert ist, um in der ersten Konfiguration eine positive Spannung an die erste (A) Elektrode und eine negative Spannung an die vierte (D) Elektrode anzulegen und in der zweiten Konfiguration eine negative Spannung an die zweite (B) Elektrode und eine positive Spannung an die dritte (C) Elektrode anzulegen.

4. Wandler nach Anspruch 1, wobei die ersten (313') und die zweiten (317) piezoelektrische Schichten entgegengesetzte Polarisationen $\vec{P}$ aufweisen und wobei die Steuerschaltung konfiguriert ist, um in der ersten Konfiguration Spannungen gleicher Polarität an die ersten (A) und vierten (D) Elektroden anzulegen und in der zweiten Konfiguration Spannungen gleicher Polarität an die zweiten (B) und dritten (C) Elektroden anzulegen.

5. Wandler nach Anspruch 4, wobei die erste piezoelektrische Schicht (313') einen positiven Pol auf ihrer Rückseite und einen negativen Pol auf ihrer Vorderseite aufweist, und die zweite piezoelektrische Schicht (317) einen negativen Pol auf ihrer Rückseite und einen positiven Pol auf ihrer Vorderseite aufweist, und wobei die Steuerschaltung konfiguriert ist, um in der ersten Konfiguration eine positive Spannung an die erste (A) Elektrode und eine positive Spannung an die vierte (D) Elektrode anzulegen und in der zweiten Konfiguration eine positive Spannung an die zweite (B) Elektrode und eine positive Spannung an die dritte (C) Elektrode anzulegen.

6. Wandler nach einem der Ansprüche 1 bis 5, wobei die Steuerschaltung konfiguriert ist, um in der ersten Konfiguration Gleichspannungen an die ersten (A) und vierten (D) Elektroden anzulegen und in der zweiten Konfiguration Gleichspannungen an die zweiten (B) und dritten (C) Elektroden anzulegen.

7. Wandler nach einem der Ansprüche 1 bis 5, wobei der Steuerkreis konfiguriert ist, um in der ersten Konfiguration variable Spannungen an die ersten (A) und vierten (D) Elektroden anzulegen und in der zweiten Konfiguration variable Spannungen an die zweiten (B) und dritten (C) Elektrode anzulegen.

8. Wandler nach Anspruch 7, wobei die Steuerschaltung Folgendes aufweist: erste (n1) und zweite (n2) Knotenpunkte zum Anlegen einer Wechsel-Steuerspannung (S);
eine erste Diode (D1), die in Durchlassrichtung zwischen dem ersten Knoten (n1) und der ersten Elektrode (A) angebracht ist; und
eine zweite Diode (D2), die In Sperrrichtung zwischen dem zweiten Knoten (n2) und der zweiten Elektrode (B) angebracht ist.

9. Wandler nach Anspruch 8, wobei die Steuerschaltung ferner eine erste Polaritätsumkehrschaltung (801) aufweist, die die erste Elektrode (A) mit der vierten Elektrode (D) verbindet, sowie eine zweite Polaritätsumkehrschaltung (803), die die zweite Elektrode (B) mit der dritten Elektrode (C) verbindet.

10. Wandler nach einem der Ansprüche 1 bis 9, wobei der Stapel, der die ersten (313; 313') und zweiten (317) piezoelektrischen Schichten und die erste leitende Schicht (315) aufweist, eine Membran (301) bildet, die an einem starren Träger (103) aufgehängte ist.

11. Wandler nach Anspruch 10, wobei die ersten (A) und zweiten (B) Elektroden gegenüberliegend an einem Mittelteil der Membran (301) angeordnet sind und wobei die dritten (C) und vierten (D) Elektroden gegenüberliegend an einem Umfangsteil der Membran (301) angeordnet sind.

12. Wandler nach einem der Ansprüche 1 bis 11, wobei die durch die Steuerschaltung an die ersten (A), zweiten (B), dritten (C) und vierten (D) Elektroden angelegten Spannungen bezüglich der ersten leitenden Schicht (315) referenziert sind.

13. Verfahren zum Steuern eines piezoelektrischen Wandlers, der Folgendes aufweist:

eine erste piezoelektrische Schicht (313; 313') aus einem nicht-ferroelektrischen Material, wobei die erste Schicht eine Vorderseite und eine Rückseite aufweist;
eine erste leitende Schicht (315), die auf der Vorderseite der ersten piezoelektrischen Schicht (313; 313') angeordnet ist;
eine zweite piezoelektrische Schicht (317) aus einem nicht-ferroelektrischen Material, die auf der Vorderseite der ersten leitenden Schicht (315) angeordnet ist;
eine erste Elektrode (A), die auf der Vorderseite der zweiten piezoelektrischen Schicht (317) angeordnet ist;
eine zweite Elektrode (B), die auf der Rückseite der ersten piezoelektrischen Schicht (313; 313') gegenüber der ersten Elektrode (A) angeordnet ist;
eine dritte Elektrode (C), die auf der Vorderseite der zweiten piezoelektrischen Schicht (317) angeordnet ist; und
eine vierte Elektrode (D), die auf der Rückseite der ersten piezoelektrischen Schicht (317), gegenüber der dritten Elektrode (C), angeordnet ist,
wobei das Verfahren Folgendes aufweist:

in einer ersten Betriebsphase, gleichzeitiges Anlegen einer Nicht-Nullspannung ($V_A$; S1) an die erste Elektrode (A), einer Nicht-Nullspannung ($V_D$; - S1) an die vierte Elektrode (D) und von im wesentlichen Nullspannungen ($V_B$, Vc; S2; -S2) an die zweiten (B) und dritten (C) Elektroden; und
in einer zweiten Betriebsphase, gleichzeitiges Anlegen einer Nicht-Nullspannung ($V_B$; S2) an die zweite Elektrode (B), einer Nicht-Nullspannung ($V_C$; - S2) an die dritte Elektrode (C), und von im wesentlichen Nullspannungen ($V_A$, $V_D$; S1, -S1) an die ersten (A) und vierten (D) Elektroden.

## Claims

1. A piezoelectric transducer comprising:

   a first piezoelectric layer (313; 313') made of a non-ferroelectric material, the first layer having a front surface and a rear surface;
   a first conductive layer (315) arranged on the front surface of the first piezoelectric layer (313; 313');
   a second piezoelectric layer (317) made of a non-ferroelectric material arranged on the front surface of the first conductive layer (315);
   a first electrode (A) arranged on the front surface of the second piezoelectric layer (317);
   a second electrode (B) arranged on the rear surface of the first piezoelectric layer (313; 313'), opposite the first electrode (A);
   a third electrode (C) arranged on the front surface of the second piezoelectric layer (317);
   a fourth electrode (D) arranged on the rear surface of the first piezoelectric layer (317), opposite the third electrode (C); and
   a control circuit configured to:

   in first operating phase, simultaneously apply a non-zero voltage ($V_A$; S1) to the first electrode (A), a non-zero voltage ($V_D$; -S1) to the fourth electrode (D), and substantially zero voltages ($V_B$, $V_C$; S2, -S2) to the second (B) and third (C) electrodes; and
   in a second operating phase, simultaneously apply a non-zero voltage ($V_B$; S2) to the second electrode (B), a non-zero voltage ($V_C$; -S2) to the third electrode (C), and substantially zero voltages ($V_A$, $V_D$; S1, -S1) to the first (A) and fourth (D) electrodes.

2. The transducer of claim 1, wherein the first (313) and second (317) piezoelectric layers have identical polarizations $\vec{P}$, and wherein the control circuit is configured to, in the first configuration, apply voltages of opposite polarities to the first (A) and fourth (D) electrodes and, in the second configuration, apply voltages of opposite polarities to the second (B) and third (C) electrodes.

3. The transducer of claim 2, wherein the first (313) and second (317) piezoelectric layers each have a negative pole on their rear surface side and a positive pole on their front surface side, and wherein the control circuit is configured to, in the first configuration, apply a positive voltage to the first (A) electrode and a negative voltage to the fourth (D) electrode and, in the second configuration, apply a negative voltage to the second (B) electrode and a positive voltage to the third (C) electrode.

4. The transducer of claim 1, wherein the first (313') and second (317) piezoelectric layers have opposite polarizations $\vec{P}$, and wherein the control circuit is configured to, in the first configuration, apply voltages of same polarity to the first (A) and fourth (D) electrodes and, in the second configuration, apply voltages of same polarity to the second (B) and third (C) electrodes.

5. The transducer of claim 4, wherein the first piezoelectric layer (313') has a positive pole on its rear surface side and a negative pole on its front surface side, and the second piezoelectric layer (317) has a negative pole on its rear surface side and a positive pole on its front surface side, and wherein the control circuit is configured to, in the first configuration, apply a positive voltage to the first (A) electrode and a positive voltage to the fourth (D) electrode and, in the second configuration, apply a positive voltage to the second (B) electrode and a positive voltage to the third (C) electrode.

6. The transducer of any of claims 1 to 5, wherein the control circuit is configured to, in the first configuration, apply DC voltages to the first (A) and fourth (D) electrodes and, in the second configuration, apply DC voltages to the second (B) and third (C) electrodes.

7. The transducer of any of claims 1 to 5, Wherein the control circuit is configured to, in the first configuration, apply variable voltages to the first (A) and fourth (D) electrodes and, in the second configuration, apply variable voltages to the second (B) and third (C) electrodes.

8. The transducer of claim 7, wherein the control circuit comprises:

   first (n1) and second (n2) nodes of application of an AC control voltage (S);
   a first diode (D1) forward-mounted between the first node (n1) and the first electrode (A); and
   a second diode (D2) reverse-mounted between the second node (n2) and the second electrode (B).

9. The transducer of claim 8, wherein the control circuit further comprises a first polarity inversion circuit (801) coupling the first electrode (A) to the fourth electrode (D) and a second polarity inversion circuit (803) coupling the second electrode (B) to the third electrode (C).

10. The transducer of any of claims 1 to 9, wherein the stack comprising the first (313; 313') and second (317) piezoelectric layers and the first conductive layer (315) forms a membrane (301) suspended on a rigid support (103).

11. The transducer of claim 10, wherein the first (A) and second (B) electrodes are arranged opposite a central portion of the membrane (301) and wherein the third (C) and fourth (D) electrodes are arranged opposite a peripheral portion of the membrane (301).

12. The transducer of any of claims 1 to 11, wherein the voltages applied by the control circuit to the first (A), second (B), third (C), and fourth (D) electrodes are referenced with respect to the first conductive layer (315).

13. A method of controlling a piezoelectric transducer comprising:

a first piezoelectric layer (313; 313') made of a non-ferroelectric material, the first layer having a front surface and a rear surface;
a first conductive layer (315) arranged on the front surface of the first piezoelectric layer (313; 313');
a second piezoelectric layer (317) made of a non-ferroelectric material arranged on the front surface of the first conductive layer (315);
a first electrode (A) arranged on the front surface of the second piezoelectric layer (317);
a second electrode (B) arranged on the rear surface of the first piezoelectric layer (313; 313'), opposite the first electrode (A);
a third electrode (C) arranged on the front surface of the second piezoelectric layer (317); and
a fourth electrode (D) arranged on the rear surface of the first piezoelectric layer (317), opposite the third electrode (C),
the method comprising:

in a first operating phase, simultaneously applying a non-zero voltage ($V_A$; S1) to the first electrode (A), a non-zero voltage ($V_D$; -S1) to the fourth electrode (D), and substantially zero voltages ($V_B$, $V_C$; S2; -S2) to the second (B) and third (C) electrodes; and
in a second operating phase, simultaneously applying a non-zero voltage ($V_B$; S2) to the second electrode (B), a non-zero voltage ($V_C$; -S2) to the third electrode (C), and substantially zero voltages ($V_A$, $V_D$; S1, -S1) to the first (A) and fourth (D) electrodes.

Fig 1

Fig 2

Fig 3

Fig 4

Fig 5

Fig 6

Fig 7

Fig 8

Fig 9

Fig 10

Fig 11

## RÉFÉRENCES CITÉES DANS LA DESCRIPTION

**Documents brevets cités dans la description**

- JP H0354383 B